# EUROPÄISCHE PATENTSCHRIFT

(11) **EP 1 364 408 B1**
(45) Veröffentlichungstag und Bekanntmachung des Hinweises auf die Patenterteilung: **16.05.2007**
(21) Anmeldenummer: 02700258.3
(22) Anmeldetag: 20.02.2002
(51) Int. Cl.: H01L 27/108, H01L 21/8242

(54) **VERFAHRENHER ZUR HERSTELLUNG EINER ELEKTRODENANORDNUNG ZUR LADUNGSSPEICHERUNG**
PRODUCTION METHOD OF AN ELECTRODE ARRANGEMENT FOR CHARGE STORAGE
PROCEDE DE PRODUCTION D'UN AGENCEMENT D'ELECTRODES POUR L'ACCUMULATION DE CHARGES

(30) Priorität: 21.02.2001 DE 10108290
(43) Veröffentlichungstag der Anmeldung: 26.11.2003
(73) Patentinhaber: Infineon Technologies AG, 81669 München (DE)
(72) Erfinder: GOLDBACH, Matthias, 01099 Dresden (DE); HECHT, Thomas, 01099 Dresden (DE)
(74) Vertreter: Barth, Stephan Manuel
(86) Internationale Anmeldenummer: PCT/EP2002/001800
(87) Internationale Veröffentlichungsnummer: WO 2002/067330

(56) Entgegenhaltungen:
- US-A- 5 047 815
- US-A- 6 022 786
- PATENT ABSTRACTS OF JAPAN vol. 010, no. 221 (E-424), 2. August 1986 (1986-08-02) & JP 61 056445 A (TOSHIBA CORP), 22. März 1986 (1986-03-22)
- PATENT ABSTRACTS OF JAPAN vol. 010, no. 192 (E-417), 5. Juli 1986 (1986-07-05) & JP 61 036965 A (TOSHIBA CORP;OTHERS: 01), 21. Februar 1986 (1986-02-21)

## Beschreibung

Die vorliegende Erfindung betrifft ein Verfahren zum Herstellen einer Elektrodenanordnung zur Ladungsspeicherung mit einer äußeren Grabenelektrode, die entlang der Wand eines in einem Substrat vorgesehenen Grabens ausgebildet ist und im Graben beiderseitig von einem ersten und zweiten Dielektrikum elektrisch isoliert ist; einer inneren Grabenelektrode, die im Graben isoliert vom zweiten Dielektikum als Gegenelektrode zur äußeren Grabenelektrode dient; und einer Substratelektrode, die außerhalb des Grabens isoliert vom ersten Dielektrikum als Gegenelektrode zur äußeren Grabenelektrode dient und die im oberen Grabenbereich mit der inneren Grabenelektrode verbunden ist.

Eine derartige Elektrodenanordnung ist aus Patent Abstracts of Japan vol. 010, no. 221 (E-424), 2. August 1986 (1986-08-02) & JP 61 056445 A (Toshiba Corp), 22. März 1986 (1986-03-22) bekannt.

Die US-A-5,985,729 offenbart eine Elektrodenanordnung zur Ladungsspeicherung, wobei in Gräben Elektrodenstopfen vorgesehen sind, welche im unteren Grabenbereich mit Substratelektroden verbunden sind. In den Gräben sind isoliert durch ein Dielektrikum gefaltete Gegenelektroden vorgesehen.

Bei dynamischen Schreib-Lese-Speichern werden 1-Transistor-Zellen eingesetzt, welche im wesentlichen aus einem Speicherkondensator und einem Auswahltransistor, der eine Speicherelektrode mit einer Bitleitung der Schaltungsanordnung im dynamischen Schreib-Lese-Speicher verbindet, besteht.

Mit einer Erhöhung der Integrationsdichte geht eine Verkleinerung der beispielsweise in dynamischen Schreib-Lese-Speichern eingesetzten Komponenten einher, somit müssen auch die 1-Transistor-Zellen verkleinert werden. Eine Verkleinerung der Zellen führt zu einer geometrischen Verkleinerung der Kondensatoren, was sich in einer Verringerung der gespeicherten Ladung auswirkt.

Herkömmliche Speicherkondensatoren sind u.a. als Trench-Kondensatoren ausgebildet, d.h. es wird ein Graben in eine Substratschicht geätzt und ein Dielektrikum sowie eine Speicherelektrode, beispielsweise dotiertes Poly-Silizium, werden eingebracht. Als Gegenelektrode wird beispielsweise ein dotiertes Siliziumsubstrat ("buried plate") verwendet.

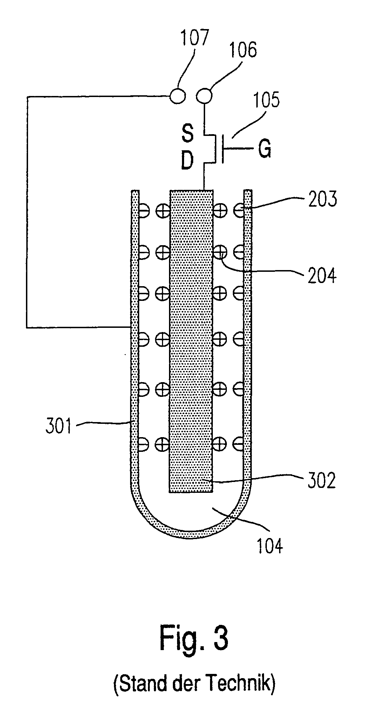

Fig. 3 zeigt einen Trench-Kondensator nach dem Stand der Technik. Hierbei ist eine grabenförmige ("Trench-") Substratelektrode 301 mit einer Substratanschlußeinrichtung 107 verbunden. Eine Füllungselektrode 302 ist mit dem Drain-Anschluß eines Auswahltransistors 105 verbunden. Ein Source-Anschluß des Auswahltransistors 105 ist mit einer Elektrodenanschlußeinrichtung 106 verbunden. Über einen Gate-Anschluß des Auswahltransistors 105 wird der Auswahltransistor 105 angesteuert und kann die Füllungselektrode 302 mit einer Bitleitung (nicht gezeigt) verbinden.

In dem in Fig. 3 gezeigten Beispiel weist die Füllungselektrode 302 eine positive Polarität auf, so daß sich positive Ladungseinheiten 204 auf der Füllungselektrode 302 befinden. Dementsprechend bilden sich auf der Substratelektrode 301 negative Ladungseinheiten 203 aus. Die gesamte speicherbare Ladung ist somit abhängig von einer Dicke eines Dielektrikums 104, einer Elektrodenoberfläche und einer Materialkonstante des Dielektrikums.

Um eine Speicherkapazität zu erhöhen, wird herkömmlicherweise die Dicke des Dielektrikums verringert. Zur Vermeidung von Leckströmen kann die Dicke des Dielektrikums nicht beliebig verringert werden. Eine Variation der Größe der Speicherkapazität kann insbesondere über eine Variation der Oberfläche der Elektrodenanordnung des Speicherkondensators erreicht werden.

Es ist somit ein Nachteil herkömmlicher Elektrodenanordnungen, daß bei einer Verkleinerung der Strukturgröße von Schreib-Lese-Speichern eine Kondensatorfläche und, dadurch bedingt, eine Kapazität von Speicherkondensatoren abnimmt.

Es ist somit eine Aufgabe der vorliegenden Erfindung, ein Verfahren zur Herstellung einer Elektrodenanordnung zur Ladungsspeicherung bereitzustellen, die derart ausgelegt ist, daß eine Erhöhung einer wirksamen Oberfläche des Speicherkondensators erreicht wird. Diese Aufgabe wird durch ein Verfahren nach Anspruch 1 gelöst.

Die erfindungsgemäße Elektrodenanordnung weist somit den Vorteil auf, daß die wirksame Oberfläche eines Speicherkondensators in dynamischen Schreib-Lese-Speichern erhöht wird.

Ein weiterer Vorteil der erfindungsgemäßen Elektrodenanordnung und des Verfahrens zum Bilden der Elektrodenanordnung besteht darin, daß kleinere Strukturgrößen erreicht werden können, ohne daß eine Kapazität von Speicherkondensatoren in dynamischen Schreib-Lese-Speichern abnimmt.

Es ist ferner vorteilhaft, daß in der erfindungsgemäßen Elektrodenanordnung und bei dem erfindungsgemäßen Verfahren zum Bilden einer Elektrodenanordnung zur Ladungsspeicherung eine Dicke eines Dielektrikums nicht verringert werden muß.

In vorteilhafter Weise wird eine Erhöhung der Leckstromdichte vermieden.

Kern der Erfindung ist eine Elektrodenanordnung zur Ladungsspeicherung, die auf einer gefalteten Speicherelektrode beruht, wobei die speicherbare Ladung wesentlich erhöht ist.

In den Unteransprüchen finden sich vorteilhafte Weiterbildungen und Verbesserungen des jeweiligen Gegenstands der Erfindung.

### ZEICHNUNGEN

Ausführungsbeispiele der Erfindung sind in den Zeichnungen dargestellt und in der nachfolgenden Beschreibung näher erläutert.

In den Figuren zeigen:
- Fig. 1: eine ebene Speicherkondensatoranordnung zur Veranschaulichung der Prinzipien der Erfindung;
- Fig. 2: einen Speicherkondensator mit einer gefalteten Speicherelektrode und einer Zwischenelektrode;
- Fig. 3: einen herkömmlichen Speicherkondensator; und
- Fig. 4a-i: Schnittansichten, die Herstellungsschritte der erfindungsgemäßen Elektrodenanordnung zur Ladungsspeicherung veranschaulichen.

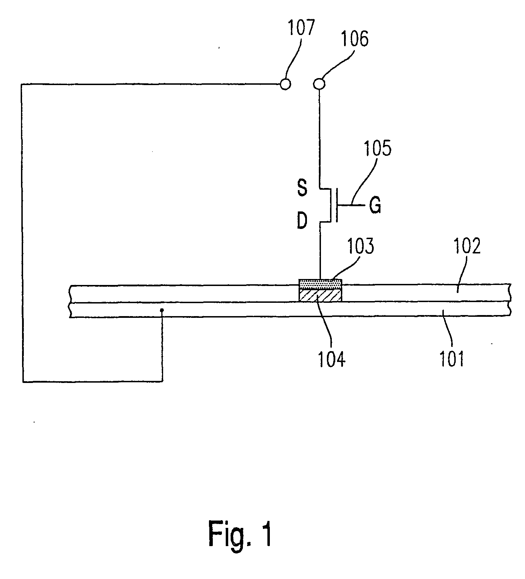

Fig. 1 zeigt eine ebene Speicherkondensatoranordnung zur Veranschaulichung der Prinzipien der Erfindung.

Bei der in Fig. 1 gezeigten prinzipiellen Elektrodenanordnung ist ein ebenes Substrat 101 mit einer Substratschicht 102 versehen. Zur Bildung eines Speicherkondensators wird ein Loch in die Substratschicht 102 geätzt, welches anschließend mit einem Dielektrikum 104 und einer Speicherelektrode 103 gefüllt wird.

Eine Gegenelektrode zu der Speicherelektrode 103 wird durch das Substrat 101 bereitgestellt, das beispielsweise aus dotiertem Poly-Silizium besteht. Die Speicherelektrode 103 ist mit einem Drain-Anschluß eines Auswahltransistors 105 verbunden. Ein Source-Anschluß des Auswahltransistors 105 ist mit einer Elektrodenanschlußeinrichtung 106 verbunden. Das Substrat 101 ist mit einer Substratanschlußeinrichtung 107 verbunden. Auf diese Weise ist es möglich, daß über einen Gate-Anschluß des Auswahltransistors 105 die als Speicherkondensator ausgebildete Speicherzelle angesteuert wird.

An Hand der in Fig. 1 gezeigten Elektrodenanordnung wird die der Erfindung zugrundeliegende Problematik erläutert.

Um eine Speicherdichte für zukünftige Technologie-Generationen weiter zu erhöhen, wird eine Strukturgröße von mikrotechnisch hergestellten Anordnungen ständig verkleinert, was zu einer Verkleinerung einer wirksamen Oberfläche des Speicherkondensators führt. Um die damit einhergehende Verringerung der gespeicherten Ladung auszugleichen, muß eine Kapazität des Speicherkondensators erhöht werden.

Dies kann beispielsweise dadurch geschehen, daß eine Dicke des Dielektrikums 104 verringert wird. Eine Verringerung einer Dicke des Dielektrikums 104 führt jedoch zu exponentiell ansteigenden Leckströmen, die zu einem Verlust der in der Speicherzelle gespeicherten Information führen.

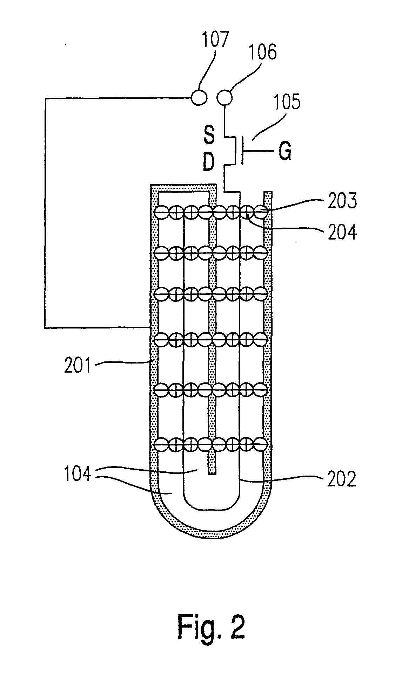

Fig. 2 zeigt einen Speicherkondensator mit einer gefalteten Speicherelektrode 201 (Substratelektrode, innere Grabenelektrode) und einer Zwischenelektrode 202 (äußere Grabenelektrode).

Die in Fig. 1 gezeigte ebene Anordnung des Speicherkondensators läßt sich erfindungsgemäße dahingehend variieren, daß eine von der ebenen Form abweichende Gestalt als Elektrodengeometrie gewählt wird.

Bei der in Fig. 2 gezeigten Elektrodenanordnung zur Ladungsspeicherung ist eine gefaltete Speicherelektrode 201 bereitgestellt, wobei in Fig. 2 eine Querschnittsansicht gezeigt ist. Eine Gegenelektrode zu der gefalteten Speicherelektrode 201 bildet eine entsprechend geformte Zwischenelektrode 202, welche mit einem Drain-Anschluß des Auswahltransistors 105 verbunden ist. Ein Source-Anschluß des Auswahltransistors 105 ist mit einer Elektrodenanschlußeinrichtung 106 verbunden, während die gefaltete Speicherelektrode mit der Substratanschlußeinrichtung 107 verbunden ist. Über einen Gate-Anschluß des Auswahltransistors 105 kann die als Speicherkondensator ausgebildete Speicherzelle angesteuert werden.

In dem in Fig. 2 gezeigten Ausführungsbeispiel liegt an der Zwischenelektrode 202 beispielsweise ein positives Potential, so daß sich dort positive Ladungseinheiten befinden, während an der gefalteten Speicherelektrode 201 beispielsweise ein negatives Potential anliegt, so daß sich dort negative Ladungseinheiten 203 befinden.

Wie in Fig. 2 veranschaulicht, wird die gespeicherte Gesamtladung, die durch die negativen und positiven Ladungseinheiten dargestellt ist, im Vergleich zur in Fig. 3 gezeigten herkömmlichen Trench-Speicherkondensatoranordnung ungefähr verdoppelt. In dem Ausführungsbeispiel der erfindungsgemäßen Elektrodenanordnung ist es somit möglich, kleinere Strukturgrößen zu erreichen, wobei eine Speicherkondensator-Kapazität aufrecht erhalten bleibt, indem eine wirksame Oberfläche des Speicherkondensators erhöht ist.

Hierbei sei darauf hingewiesen, daß durch das Ausführungsbeispiel der erfindungsgemäßen Elektrodenanordnung eine Dicke des Dielektrikums nicht verringert werden muß, so daß eine Erhöhung der Leckstromdichte nicht auftritt. Typischerweise betragen in einem Ausführungsbeispiel der vorliegenden Erfindung die Dicken des Dielektrikums 5 nm, während die Dicke der Zwischenelektrode 10-20 nm beträgt. Die Zwischenelektrode kann beispielsweise aus dotiertem Poly-Silizium oder aus einem Metall bestehen. Insgesamt ergibt sich damit für die "Trenchkondensator"-Elektrodenanordnung bei einem Durchmesser von 90 nm nach einer Abscheidung der Zwischenelektrode 202 und zweier dielektrischer Schichten 104 ein Füllungsbereich von etwa 30-50 nm Durchmesser.

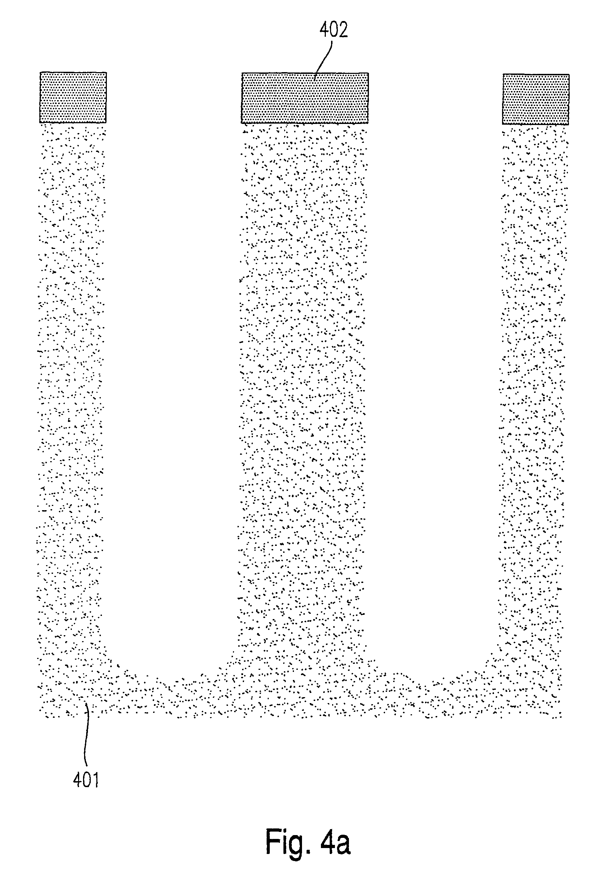

Im Folgenden seien die in den Fig. 4a-4i dargestellten Verfahrensschritte näher beschrieben. Fig. 4a bis 4i zeigen Schnittansichten, die Herstellungsschritte der erfindungsgemäßen Elektrodenanordnung zur Ladungsspeicherung veranschaulichen. Hierbei sind einzelne Herstellungsschritte verdeutlicht, die ein Verfahren zum Herstellen einer erfindungsgemäßen Elektrodenanordnung zur Ladungsspeicherung bilden.

Fig. 4a zeigt zwei Gräben ("Trenches") DT, die benachbart in ein Substratmaterial 401 vertikal geätzt sind (DT-Ätzen = "Deep Trench" - Ätzen), wobei das Substratmaterial 401 mit einer ersten Nitridschicht 402 abgedeckt ist. Es sei darauf hingewiesen, daß die Fig. 4a-4i Schnittansichten zweier benachbarter Speicherkondensatoren sind, die Speicherzellen bilden.

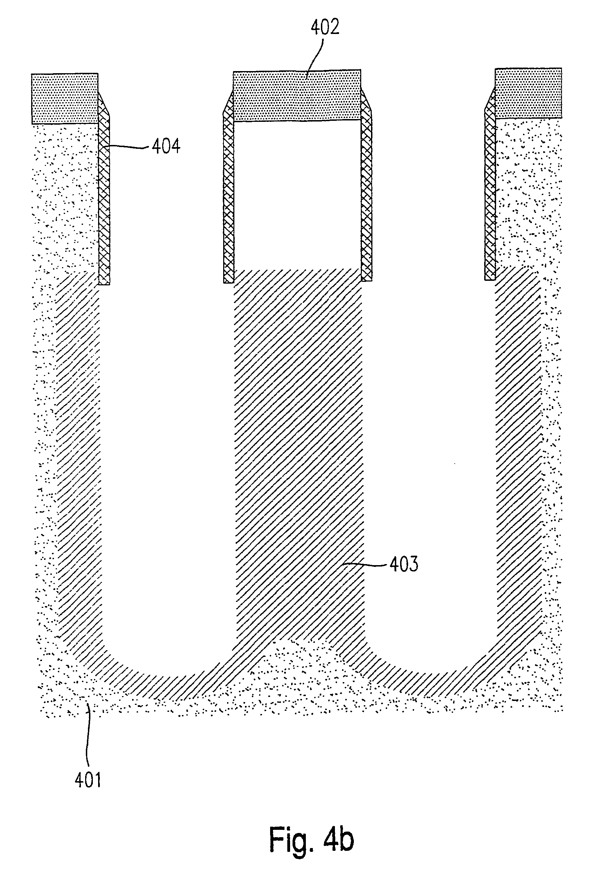

Als eine Elektrodenoberfläche wird anschließend, wie in Fig. 4b gezeigt, eine Elektrodenplatte 403 mittels einer "buried plate"-Dotierung hergestellt, und zwar durch Ausdiffusion aus einem As-Glas oder Gasphasendotierung.

Zwischen der ersten Nitridschicht 402 und der Elektrodenplatte 403 wird an den Innenwänden des Grabens ("Trench") eine Oxid-Kragenschicht 404 aufgebracht. Diese kann alternativ auch vergraben integriert sein, so daß die freiliegende Oxidschicht mit den Innenwänden der Gräben eine Linie bildet.

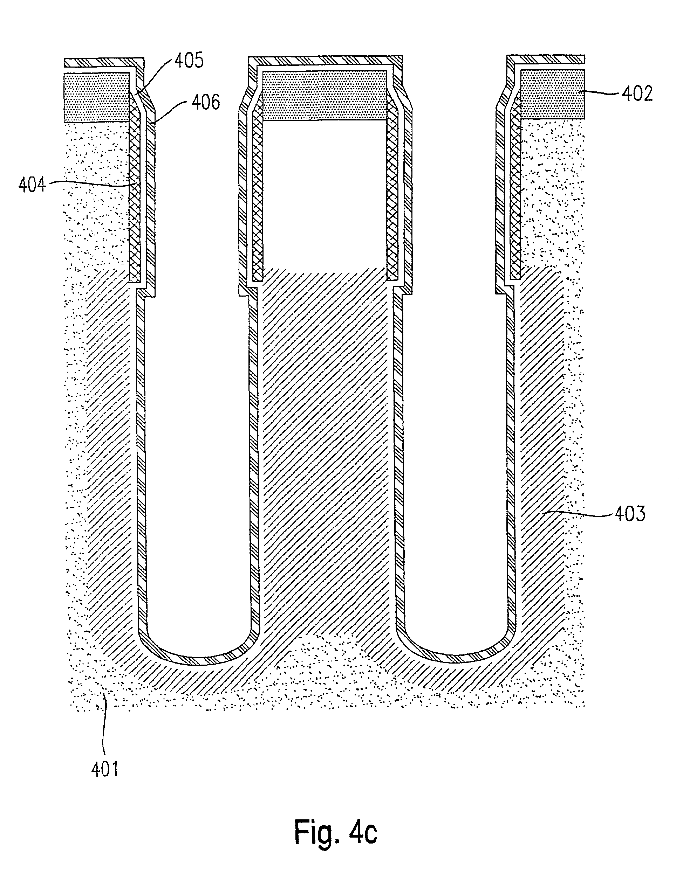

Im nächsten Herstellungsschritt wird, wie in Fig. 4c veranschaulicht, eine erste Dielektrikumsschicht 405 an den Innenflächen der Gräben aufgebracht, die als Dielektrikum für die als Speicherkondensator auszubildende Elektrodenanordnung dient.

Weiterhin wird eine Elektrodenschicht 406, die beispielsweise aus Poly-Silizium oder aus einem Metall bestehen kann, abgeschieden.

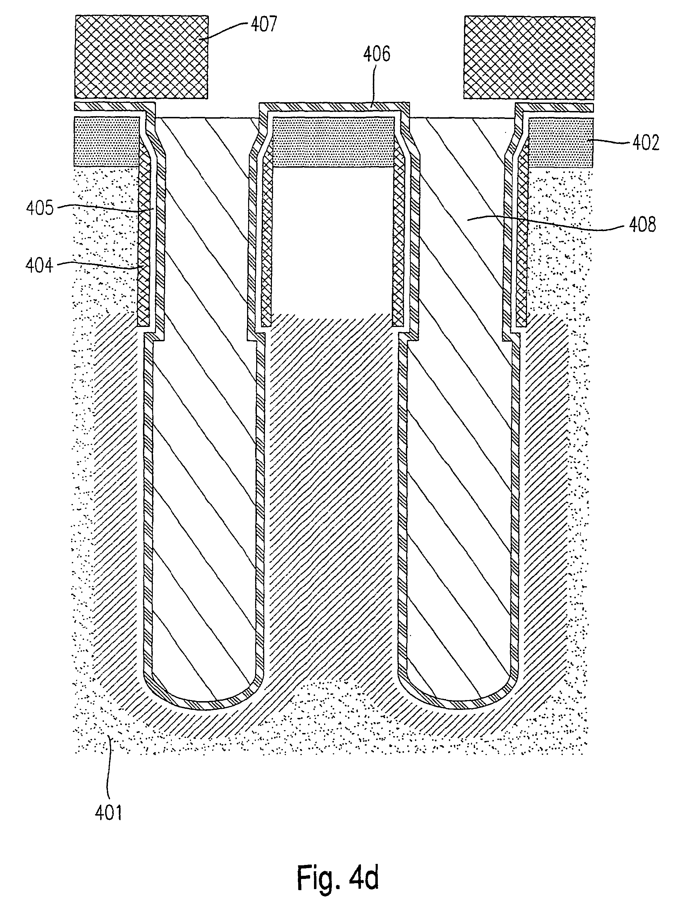

Der nächste Herstellungsschritt umfaßt, wie in Fig. 4d gezeigt, die Aufbringung einer Lithographie-Maske in der Form einer Maskenschicht 407, wobei die Maskenschicht 407 den gesamten Bereich bis auf den mittleren Teil zwischen zwei Gräben maskiert, wobei der nicht maskierte Bereich in Fig. 4d derjenige Bereich ist, der zentral zwischen der Maskenschicht 407 freigelegt ist. Außerdem ist aus Fig. 4d ersichtlich, daß eine organische ARC- ("Antireflective Coating") Antireflexschicht 408 in die Gräben eingebracht wird.

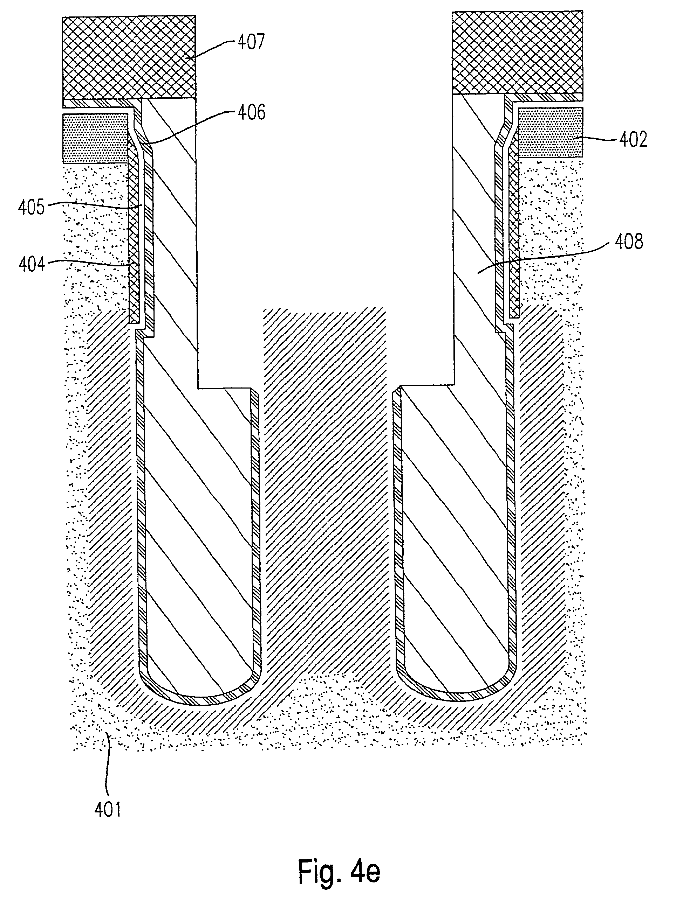

Schließlich wird, wie in Fig. 4e gezeigt, die Antireflexschicht 408 geöffnet, so daß eine Ätzung der Elektrodenschicht 406, der Dielektrikumsschicht 405 und der Oxid-Kragenschicht 404 in dem mittleren Bereich zwischen zwei Gräben ermöglicht wird. Gegebenenfalls muß im mittleren Bereich die Elektrodenschicht 406 naßchemisch weitergeätzt werden, um die Dielektrikumsschicht 405 freizulegen, damit die Dielektrikumsschicht 405 über die Elektrode ragt, wie in Fig. 4e gezeigt.

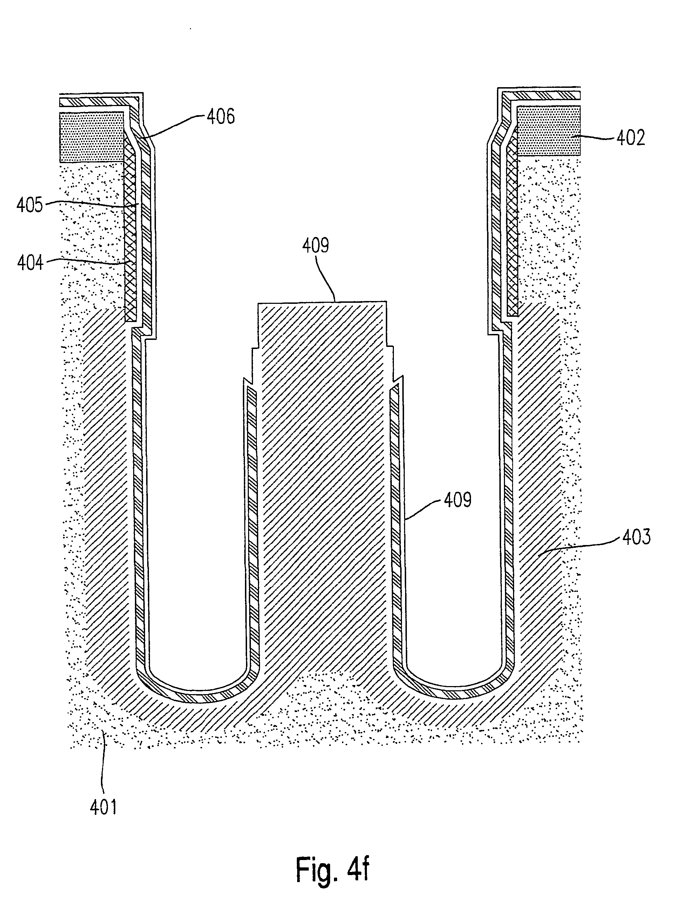

Schließlich wird in dem in Fig. 4f gezeigten Herstellungsschritt nach Entfernen des organischen ARC eine zweite Dielektrikumsschicht 409 abgeschieden. Diese zweite Dielektrikumsschicht 409 bedeckt nun sämtliche exponierten Oberflächen.

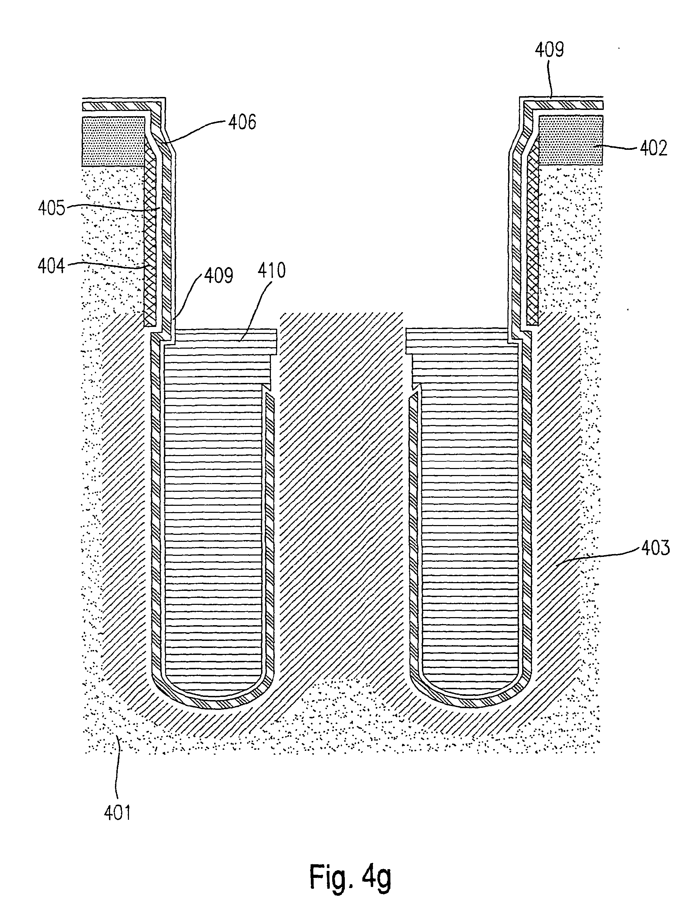

Eine Füllelektrodenschicht 410 wird anschließend, wie in Fig. 4g gezeigt, in den beiden veranschaulichten Gräben aufgebracht und zurückgeätzt, wobei die Füllelektrodenschicht 410 als dritte Elektrodenschicht neben der Elektrodenplatte 403 und der Elektrodenschicht 406 dient.

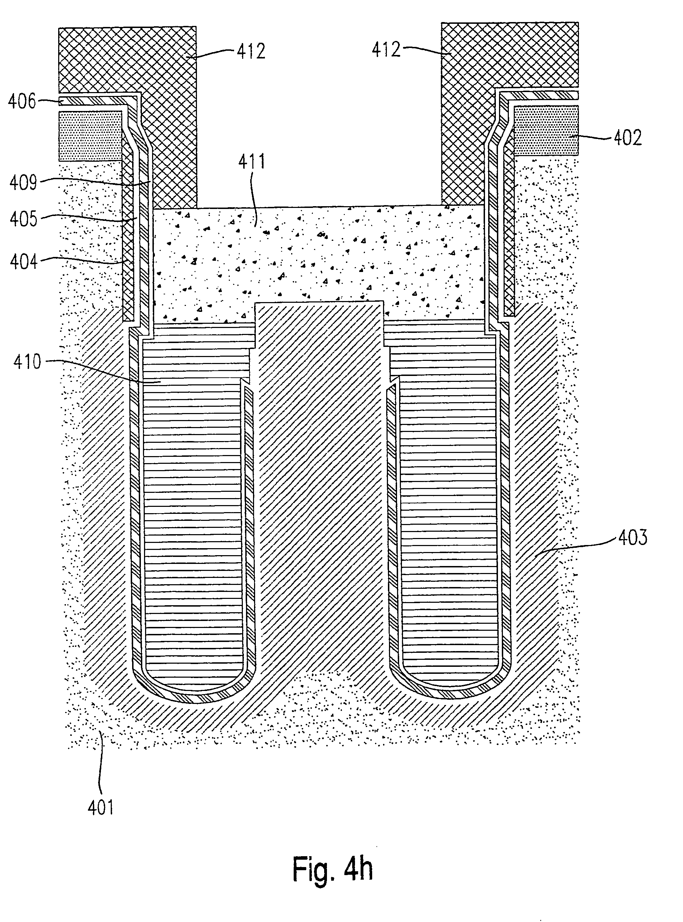

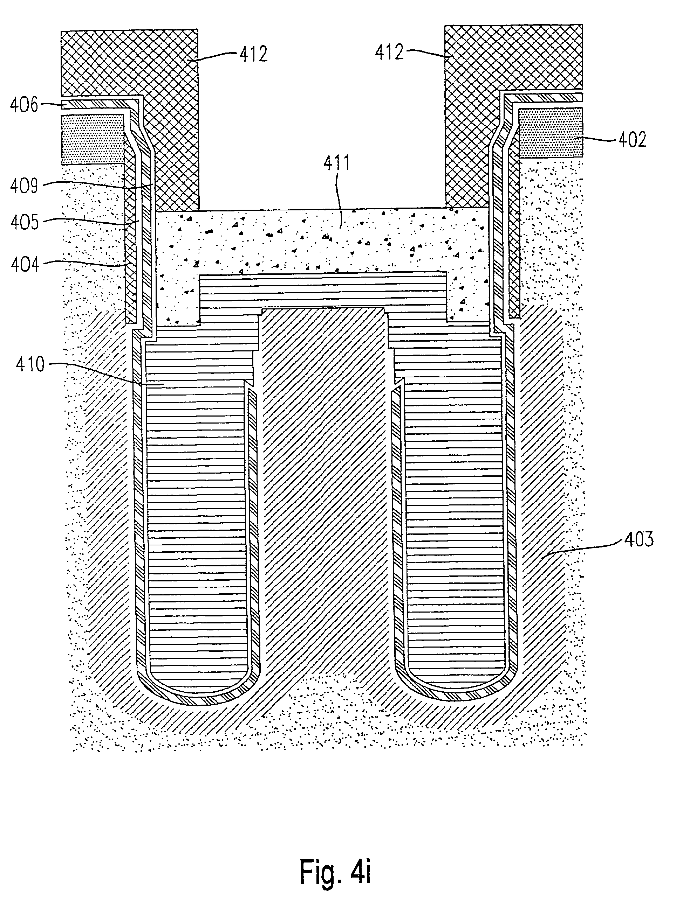

Im nächsten Herstellungsschritt wird, wie in Fig. 4h gezeigt, eine zweite Oxidschicht 411 über den aufgefüllten Gräben auf die Füllelektrodenschicht 410 bzw. auf Teile der zweiten Dielektrikumsschicht 409 abgeschieden und zurückgeätzt. Es sei darauf hingewiesen, daß die zweite Oxidschicht 411 beispielsweise auch durch einen HDP- Prozess (High Density Plasma = Hochdichteplasma) abgeschieden werden kann.

Als Maske wird, wie ebenfalls in Fig. 4h gezeigt, eine zweite Nitridschicht 412 abgeschieden, welche im mittleren Bereich über den beiden Gräben geöffnet wird.

Schließlich wird im letzten Herstellungsschritt gemäß Fig. 4i die zweite Oxidschicht 411 im nicht-maskierten Bereich trockenchemisch entfernt, wobei ein Bereich der Elektrodenplatte 403 von der zweiten Dielektrikumsschicht 409 befreit wird, so daß eine anschließende Abscheidung einer Füllelektrodenschicht 410 (Poly-Silizium) ebenfalls durch HDP-Abscheidung ermöglicht wird.

Optionellerweise erfolgt vor der Abscheidung des Poly-Siliziums die Abscheidung einer dünnen (ca. 1 nm) Nitridschicht zur Vermeidung des Weiterwachsens von Versetzungen.

Auf diese Weise sind die beiden mit der Füllelektrodenschicht 410 befüllten Gräben unterhalb der zweiten Oxidschicht 411 elektrisch verbunden. Die resultierende Struktur wird schließlich mit HDP-Oxid aufgefüllt.

Somit ist eine Elektrodenanordnung zur Ladungsspeicherung, wie sie ebenfalls in Fig. 2 schematisch gezeigt ist, gebildet.

Die gezeigten Elektrodenanordnungen, Substrate und Anschlüsse sind nur beispielhaft dargestellt und sind nicht auf die gezeigten Größen bzw. Größenverhältnisse beschränkt.

Obwohl die vorliegende Erfindung vorstehend anhand bevorzugter Ausführungsbeispiele beschrieben wurde, ist sie darauf nicht beschränkt, sondern auf vielfältige Weise modifizierbar.

### Bezugszeichenliste

| | |
|---|---|
| 101 | Substrat |
| 102 | Substratschicht |
| 103 | Speicherelektrode |
| 104 | Dielektrikum |
| 105 | Auswahltransistor |
| 106 | Elektrodenanschlußeinrichtung |
| 107 | Substratanschlußeinrichtung |
| 201 | Gefaltete Speicherelektrode |
| 202 | Zwischenelektrode |
| 203 | Negative Ladungseinheiten |
| 204 | Positive Ladungseinheiten |
| 301 | Substratelektrode |
| 302 | Füllungselektrode |
| 401 | Substratmaterial |
| 402 | Erste Nitridschicht |
| 403 | Elektrodenplatte |
| 404 | Oxid-Kragenschicht |
| 405 | Erste Dielektrikumsschicht |
| 406 | Elektrodenschicht |
| 407 | Maskenschicht |
| 408 | Antireflexschicht |
| 409 | Zweite Dielektrikumsschicht |
| 410 | Füllelektrodenschicht |
| 411 | Zweite Oxidschicht |
| 412 | Zweite Nitridschicht |
| ARC | Anti reflective coating |
| BPC | Buried plate self aligned CVD collar |
| CVD | Chemical vapour deposition |
| DT | Deep trench, Graben |
| GDP | Gas phase doping |
| HDP | High density plasma |

## Patentansprüche

1. Verfahren zum Herstellen einer Elektrodenanordnung zur Ladungsspeicherung mit:
a) einer äußeren Grabenelektrode (406), die entlang der Wand eines in einem Substrat (401) vorgesehenen Grabens ausgebildet ist und im Graben beiderseitig von einem ersten und zweiten Dielektrikum (405, 409) elektisch isoliert ist;
b) einer inneren Grabenelektrode (410), die im Graben isoliert vom zweiten Dielektrikum (409) als Gegenelektrode zur äußeren Grabenelektrode (406) dient; und
c) einer Substratelektrode (403), die außerhalb des Grabens isoliert vom ersten Dielektrikum (405) als Gegenelektrode zur äußeren Grabenelektrode (406) dient und die im oberen Grabenbereich mit der inneren Grabenelektrode (410) verbunden ist;
welches folgende Schritte aufweist:
a) Bilden von nebeneinanderliegenden Gräben in dem Substrat (401) ;
b) Vorsehen der Substratelektroden (403) im unteren Grabenbereich;
c) Bilden einer Oxid-Kragenschicht (404) im oberen Grabenbereich;
d) Aufbringen des ersten Dielektrikums (405);
e) Vorsehen einer ersten Elektrodenschicht entsprechend den äußeren Grabenelektroden (406) auf dem ersten Dielektrikum (405);
f) Entfernen der ersten Elektrodenschicht (406) des ersten Dielektrikums (405), der Oxid-Kragenschicht (404) und des Substrats (401) oberhalb der Substratelektroden (403) in dem mittleren Bereich zwischen Paaren von benachbarten Gräben;
g) Aufbringen des zweiten Dielektrikums (409);
h) Einbringen einer zweiten Elektrodenschicht entsprechend der inneren Grabenelektroden (410) in die Gräben; und
i) Vorsehen einer elektrischen Verbindung zwischen den zweiten Elektrodenschichten zwischen den Paaren von benachbarten Gräben.

2. Verfahren zum Herstellen einer Elektrodenanordnung zur Ladungsspeicherung nach Anspruch 1, **dadurch gekennzeichnet, daß** eine konstante Dicke des ersten und zweiten Dielektrikums (405, 409) im Graben vorgesehen wird.

3. Verfahren zum Herstellen einer Elektrodenanordnung zur Ladungsspeicherung nach Anspruch 1 oder 2, **dadurch gekennzeichnet, daß** die innere Grabenelektrode (410) und/oder die äußere Grabenelektrode (406) aus dotiertem Poly-Silizium ausgeführt wird.

4. Verfahren zum Herstellen einer Elektrodenanordnung zur Ladungsspeicherung nach Anspruch 1 oder 2, **dadurch gekennzeichnet, daß** die innere Grabenelektrode (410) und/oder die äußere Grabenelektrode (406) aus einem Metall ausgeführt wird.

5. Verfahren zum Herstellen einer Elektrodenanordnung zur Ladungsspeicherung nach Anspruch 1 oder 2, **dadurch gekennzeichnet, daß** die innere Grabenelektrode (410) und/oder die äußere Grabenelektrode (406) aus einem Metallnitrid ausgeführt wird.

## Claims

1. A method for manufacturing an electrode arrangement for storing charge comprising:
a) an outer trench electrode (406) formed along the wall of a trench provided in a substrate (401) and being electrically isolated in the trench on both sides by means of a first and second dielectrics (405, 409);
b) an inner trench electrode (410) isolated in the trench by means of the second dielectric (409) serving as a counter electrode to the outer trench electrode (406); and
c) a substrate electrode (403) isolated by means of the first dielectric (405) outside of the trench serving as a counter electrode to the outer trench electrode (406) and being contacted to the inner trench electrode (410) in the upper trench region;
comprising the following steps:
a) forming of neighbouring trenches in the substrate (401);
b) providing said substrate electrodes (403) in a lower region;
c) forming an oxide collar layer (404) in the upper trench region;
d) depositing the first dielectric (405);
e) providing a first electrode layer corresponding to the outer trench electrodes (406) on the first dielectric (405);
f) removing the first electrode layer (406), the first dielectric (405), the oxide collar layer (404) and the substrate (401) above the substrate electrodes (403) in a middle area between areas of neighbouring trenches;
g) depositing the second dielectric (409);
h) introducing a second electrode layer corresponding to the inner trench electrodes (410) into the trenches; and
i) providing an electric connection between the two neighbouring electrode layers between the pairs of neighbouring trenches.

2. The method for manufacturing an electrode arrangement for storing charge according to claim 1, **characterised in that** a constant thickness of the first and second dielectrics (405, 409) is provided in the trench.

3. The method for manufacturing an electrode arrangement for storing charge according to claim 1 or 2, **characterised in that** the inner trench electrode (410) and/or the outer trench electrode (406) is made of doped poly-silicon.

4. The method for manufacturing an electrode arrangement for storing charge according to claim 1 or 2, **characterised in that** the inner trench electrode (410) and/or the outer trench electrode (406) is made of a metal.

5. The method for manufacturing an electrode arrangement for storing charge according to claim 1 or a 2, **characterised in that** the inner trench electrode (410) and/or the outer trench electrode (406) is made of a metal nitride.

## Revendications

1. Procédé pour la fabrication d'un dispositif d'électrodes pour l'accumulation de charge comprenant :
a) une électrode de tranchée extérieure (406) formée le long de la paroi d'une tranchée prévue dans un substrat (401) et qui est isolée dans la tranchée des deux côtés par un premier et un deuxième diélectrique (405, 409) ;
b) une électrode de tranchée intérieure (410) qui sert, dans la tranchée, isolée par le deuxième diélectrique (409), de contre-électrode pour l'électrode de tranchée extérieure (406) ; et
c) une électrode de substrat (403) qui sert, à l'extérieur de la tranchée, isolée par le premier diélectrique (405), de contre-électrode pour l'électrode de tranchée extérieure (406) et qui est reliée dans la zone supérieure de la tranchée avec l'électrode de tranchée intérieure (410) ;
comprenant les étapes suivantes consistant à :
a) Former des tranchées l'une à coté de l'autre dans le substrat (401) ;
b) Prévoir les électrodes de substrat (403) dans la zone inférieure de tranchée ;
c) Former une couche d'oxyde à collet (404) dans la zone supérieure de tranchée;
d) Appliquer le premier diélectrique (405);
e) Prévoir une première couche d'électrodes, correspondant aux électrodes de tranchée extérieures (406), sur le premier diélectrique (405) ;
f) Retirer la première couche d'électrodes (406), du premier diélectrique (405), de la couche d'oxyde à collet (404) et du substrat (401) au-dessus des électrodes de substrat (403) dans la zone médiane entre des paires de tranchées voisines ;
g) Appliquer le deuxième diélectrique (409) ;
h) Introduire, dans les tranchées, une deuxième couche d'électrodes correspondant aux électrodes de tranchée intérieures (410) ; et
i) Prévoir une liaison électrique entre les deux couches d'électrodes, entre les paires de tranchées voisines.

2. Procédé pour la fabrication d'un dispositif d'électrodes pour l'accumulation de charge selon la revendication 1, **caractérisé en ce qu'**on prévoit une épaisseur constante dans la tranchée pour le premier et le deuxième diélectrique (405, 409).

3. Procédé pour la fabrication d'un dispositif d'électrodes pour l'accumulation de charge selon la revendication 1 ou 2, **caractérisé en ce que** l'électrode de tranchée (410) intérieure et/ou l'électrode de tranchée extérieure (406) sont réalisées en polysilicium dopé.

4. Procédé pour la fabrication d'un dispositif d'électrodes pour l'accumulation de charge selon la revendication 1 ou 2, **caractérisé en ce que** l'électrode de tranchée (410) intérieure et/ou l'électrode de tranchée extérieure (406) sont réalisées en métal.

5. Procédé pour la fabrication d'un dispositif d'électrodes pour l'accumulation de charge selon la revendication 1 ou 2, **caractérisé en ce que** l'électrode de tranchée (410) intérieure et/ou l'électrode de tranchée extérieure (406) sont réalisées en nitrure de métal.
